# EUROPEAN PATENT APPLICATION

(11) **EP 3 650 580 A1**
(43) Date of publication of application: **13.05.2020**
(21) Application number: 18205781.0
(22) Date of filing: 12.11.2018
(51) Int. Cl.: C23C 24/04, C23C 4/04, C23C 4/134, C23C 16/448

(54) **IMPROVED METHOD FOR PLASMA IMMOBILIZATION OF A BIOMOLECULE TO A SUBSTRATE VIA A LINKING MOLECULE**

(71) Applicant: Molecular Plasma Group SA, 3895 Foetz (LU)
(72) Inventor: Scheltjens, Gill, 3895 Foetz (LU); Heyberger, Régis, 3895 Foetz (LU)
(74) Representative: IPLodge bv

(57) **Abstract**

The current invention relates to a two step method for the immobilization of a biomolecule through a linking molecule on a sample surface of a substrate by generating and maintaining a non-thermal atmospheric pressure plasma at a temperature between room temperature and 60°C. The preferred plasma temperature is room temperature. The method comprises of a first step and second step, which are sequentially carried out. In the first step of the method, the linking molecule is deposited onto the sample surface through exposing the sample surface to a first plasma jet and the linking molecule, generating a linking layer onto the sample surface. In a second sequential step of the method, the biomolecule is deposited onto the linking layer through exposing the linking layer to a second plasma jet and the biomolecule.

## Description

### FIELD OF THE INVENTION

The present invention is related to plasma techniques, particularly involving the inclusion of biological molecules into a plasma deposited layer.

### BACKGROUND

WO 2017/136334 A1 discloses methods for depositing biomolecules, pharmaceutical agents, and other therapeutic active agents onto surfaces. The method includes a plasma device having one or more electrodes, a gas supply inlet, a plasma outlet exposed to ambient pressure, and an ignition system operatively connected to the electrodes for providing a non-themal equilibrium plasma within the plasma chamber. A particulate delivery system may be used to introduce the active agent as a dry powder into or downstream of the plasma, and to deposit the plasma-treaded active agent(s) to produce a coating on a surface. The coating may retain the activity of the active agent(s). This invention attempts to solve the problem of eliminating any wet chemical steps in order to obtain an at least two layered biological coating onto a substrate, using non-thermal atmospheric plasma. However, this method is not suitable for many combinations of substrate and biomolecules due to the harsh plasma conditions which the biomolecules are subjected to.

WO 2005/106477 discloses method for immobilizing a biomolecule on a surface by generating and maintaining an atmospheric pressure plasma. The immobilization is achieved by introducing a sample in the space between two electrodes, by applying an alternating voltage to the electrodes a plasma is generated and a coating is deposited. The present mixed atmosphere comprises an aerosol comprising a reactive precursor and an aerosol comprising a biomolecule, both of which are deposited and immobilized during the depositing step. This method is also not suitable for many combinations of substrate and biomolecules. Another disadvantage of this method is the efficiency of the biomolecule immobilization. Simultaneous deposition of both the linking molecule and biomolecule can result in steric hindrance, limiting the amount of biomolecules deposited. Moreover, deposition of a first linking layer can increase the amount of biomolecules immobilised onto the surface.

The present invention aims to resolve at least some of the problems and disadvantages mentioned above. The aim of the invention is to provide a method which eliminates those disadvantages.

### SUMMARY OF THE INVENTION

In a first aspect, the invention provides for a two step method for the immobilization of a biomolecule through a linking molecule on a sample surface of a substrate by generating and maintaining a non-thermal atmospheric pressure plasma, according to claim 1.

The method according to the present invention allows for a much broader selection of combinations of substrates and biomolecules. Particularly the combination of relatively inert substrates and substrates to which binding biomolecules proved difficult, and biomolecules which are plasma-sensitive can advantageously be immobilized through the present invention. This can be done through the choice of a suitable linking layer and corresponding plasma conditions for both steps.

The presence of the linking layer allows for a more efficient biomolecule immobilization in terms of the amount of biomolecules bound, the ability to control the orientation of the biomolecule immobilization or both. Further, the immobilization through the linking layer by the usage of plasma technology, results in a simple two step method without the need for time consuming, complex, multi-step, wet chemical processes. This also excludes the use of expensive and environmentally harmful solvents.

In a second aspect, the invention provides an apparatus adequate for the two step immobilization of the biomolecule onto the sample surface of the substrate through a linking molecule, according to claim 10.

The apparatus is advantageously adapted for the two-step process according to the invention. The apparatus is suitable for regular atmospheric non-thermal plasmas. However, the apparatus is particularly suitable for plasma-sensitive biomolecules.

The apparatus is adapted to create a relatively homogeneous plasma along the substrate surface, due to the nozzle. Furthermore, the nozzle creates a slight overpressure with respect to the environment, due to which environmental oxygen is largely excluded. Without oxygen deactivating ionized molecules prior to said molecules reaching the surface, a much more homogeneous plasma is created. This also allows milder plasma conditions along the jet while still retaining sufficient energy to deposit molecules onto the surface or the linking layer.

In a third aspect, the invention discloses devices obtainable using the two step immobilization of the biomolecule onto the sample surface of the substrate through a linking molecule, according to claim 13.

The broader combination of substrates and biomolecules which can be combined through the method of the present invention allows for novel or improved applications or products. These applications can be found in but are not limited to the medical, chemical, environmental, food, materials industry. Particular products include but are not limited to biosensors, labs-on-chips, bio-mimetic materials, solar cells, non-fouling surfaces, anti-microbial coatings, templates for extra-corporeal or in-vivo growth or both of functional tissues, bio-induced crystalline morphologies, conducting coatings or bio-catalysis applications.

Advantageously, the invention offers a solution for the industrialization limits induced by using wet chemical steps in the production of medical devices, wound care products, biosensor, lab-on-chips, non-fouling surfaces and anti-microbial coatings. One particular examples include the immobilization of biomolecules on glass, quartz or silicon wafers for research and diagnostics. Another is the immobilization of biomolecules, particularly with anti-bacterial or anti-fungal properties onto textiles for wound dressing.

### DESCRIPTION OF FIGURES

**Figure 1** shows the interaction between reagents in the sandwich ELISA.
**Figure 2** shows the comparison of the functionality of plasma deposited antibodies to those deposited by traditional wet chemical methods.
**Figure 3** shows the relationship between blank and positive samples (Ab + AA, no incubation, 4 slm, 9 s).
**Figure 4** shows the relationship between blanks and positive samples (Ab only, no incubation, 2 slm, different exposure times), and the relationship between a control sample containing no capture antibody and positives.
**Figure 5** shows the relationship between blanks and positive samples (Ab only, no incubation, different suction flow, 10 s).
**Figure 6** shows compare the effect of different incubation methods on the functionality of antibodies after immobilization using atmospheric plasma (Ab + AA).
**Figure 7** shows compare the effect of different incubation methods on the functionality of antibodies after immobilization using atmospheric plasma (Ab only).
**Figure 8** shows the comparison of the functionality of antibodies immobilized with and without the simultaneous plasma polymerization of acrylic acid.
**Figure 9** shows the effect of suction flow on the endpoint of an ELISA.
**Figure 10** shows the effect of exposure time on the endpoint of an ELISA (no incubation).
**Figure 11** show the effect of exposure time on the endpoint of an ELISA (wet incubation).
**Figure 12** shows the effect of exposure time on the endpoint of an ELISA (1 slm, no incubation, Ab + AA).
**Figure 13** shows the effect of exposure time on the endpoint of an ELISA (4 slm, no incubation, Ab + AA.

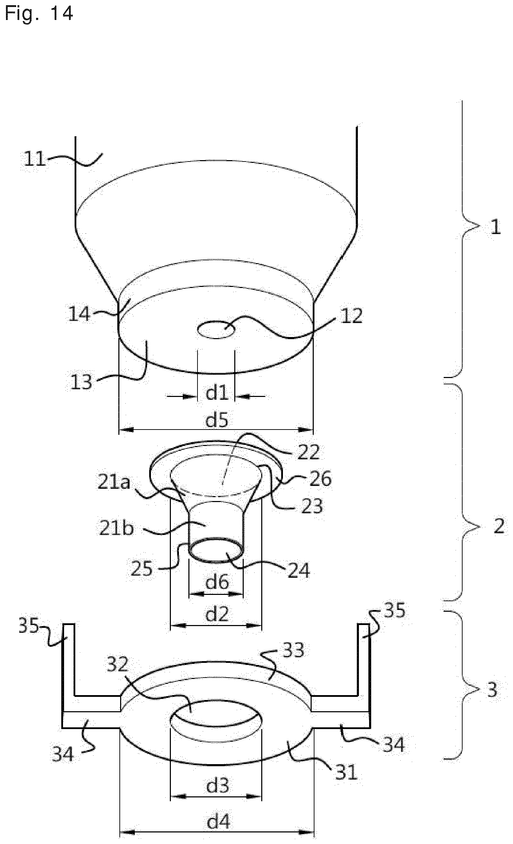

**Figure 14** show a front view of an embodiment of the apparatus according to the present invention.

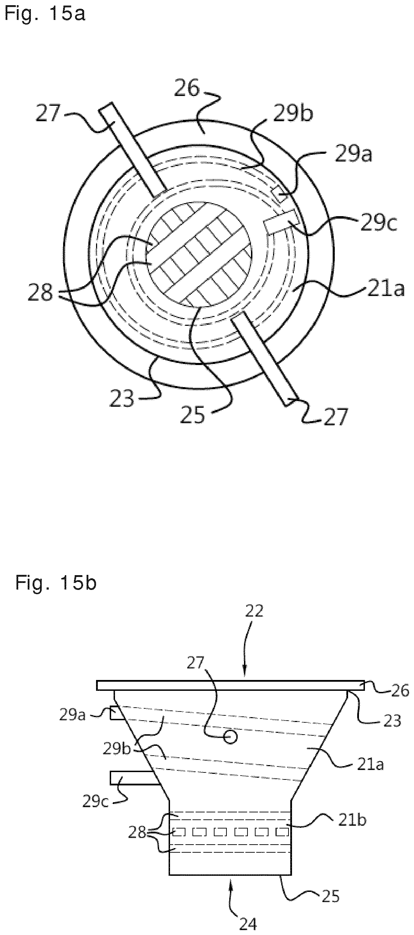

**Figures 15a and 15b** show, respectively, a longitudinal view and a side view of an embodiment of a shield according to the present invention.

### DETAILED DESCRIPTION OF THE INVENTION

The present invention concerns a two step method and an apparatus for the immobilization of a biomolecule through a linking molecule on a sample surface of a substrate via a non-thermal atmospheric pressure plasma. The invention is summarized in the corresponding section above. In what follows, the invention is described in detail, preferred embodiments are discussed, and the invention is illustrated via examples.

Unless otherwise defined, all terms used in disclosing the invention, including technical and scientific terms, have the meaning as commonly understood by one of ordinary skill in the art to which this invention belongs. By means of further guidance, term definitions are included to better appreciate the teaching of the present invention.

As used herein, the following terms have the following meanings:
"A", "an", and "the" as used herein refers to both singular and plural referents unless the context clearly dictates otherwise. By way of example, "a compartment" refers to one or more than one compartment.

"About" as used herein referring to a measurable value such as a parameter, an amount, a temporal duration, and the like, is meant to encompass variations of +/-20% or less, preferably +/-10% or less, more preferably +/-5% or less, even more preferably +/-1% or less, and still more preferably +/-0.1% or less of and from the specified value, in so far such variations are appropriate to perform in the disclosed invention. However, it is to be understood that the value to which the modifier "about" refers is itself also specifically disclosed.

"Comprise", "comprising", and "comprises" and "comprised of" as used herein are synonymous with "include", "including", "includes" or "contain", "containing", "contains" and are inclusive or open-ended terms that specifies the presence of what follows e.g. component and do not exclude or preclude the presence of additional, non-recited components, features, element, members, steps, known in the art or disclosed therein.

Furthermore, the terms first, second, third and the like in the description and in the claims, are used for distinguishing between similar elements and not necessarily for describing a sequential or chronological order, unless specified. It is to be understood that the terms so used are interchangeable under appropriate circumstances and that the embodiments of the invention described herein are capable of operation in other sequences than described or illustrated herein.

The recitation of numerical ranges by endpoints includes all numbers and fractions subsumed within that range, as well as the recited endpoints.

Whereas the terms "one or more" or "at least one", such as one or more or at least one member(s) of a group of members, is clear *per se,* by means of further exemplification, the term encompasses *inter alia* a reference to any one of said members, or to any two or more of said members, such as, e.g., any ≥3, ≥4, ≥5, ≥6 or ≥7 etc. of said members, and up to all said members.

"Sample surface" as used herein denotes a part or the whole surface of a substrate. Preferably the sample surface has a surface of at least 1 µm².

"Linking layer" as used herein denotes a layer comprising of the linking molecule which can either undergo polymerization or remain as a monomer on the surface upon deposition.

"Plasma jet" as used herein refers to a plasma jet and/or an afterglow of the plasma jet. For example, coating precursors injected into the "plasma jet" inside the shield may refer to coating precursors injected into the plasma jet and/or an afterglow of the plasma jet inside the shield.

"Moiety" as used herein denotes a part of a molecule which is given a name as it can be found within other kinds of molecules as well. Moiety as defined herein, comprises of at least one functional group or at least one smaller moiety or a combination thereof.

"Biomolecule" as used herein denotes molecules or ions that are present in organisms, particularly those that are essential to some typical biological process, as well as all biologically and pharmaceutically active molecules. This includes synthetic chemicals which show biological or pharmaceutical activity, even if they are not present "in nature".

"A biologically or pharmaceutically active molecule" as described herein relates to a molecule which has biological activity or pharmacological activity on living matter. That is to say the molecule relates to effects, either beneficial or adverse, on living matter.

In a first aspect, the invention provides for a two step method for the immobilization of a biomolecule through a linking molecule on a sample surface of a substrate by generating and maintaining a non-thermal atmospheric pressure plasma at a temperature between room temperature and 60°C. The preferred plasma temperature is room temperature. Room temperature is understood to be between 5°C and 25°C, more preferably between 15°C and 25°C, most preferably about 20°C. The method comprises of a first step and second step, which are carried out sequentially. In the first step of the method, the linking molecule is deposited onto the sample surface through exposing the sample surface to a first plasma jet and the linking molecule, generating a linking layer onto the sample surface. In a second, sequential step of the method, the biomolecule is deposited onto the linking layer through exposing the linking layer to a second plasma jet and the biomolecule.

A linking layer is often required to improve the adhesion between the surface of the substrate and the biomolecule. A two-step process is advantageous as it allows the use of different plasma conditions for the generation of the linking layer and the immobilization of the biomolecule. This is particularly advantageous when using surfaces which require harsh plasma treatments or when immobilizing biomolecules which are plasma-sensitive.

"Atmospheric pressure" as used herein denotes that the pressure *approximately* or *about* matches that of the surrounding environment. The term distinguishes the present plasma technology with low- and high-pressure plasma technologies which require a reaction vessel to maintain a substantial pressure difference with the environment. One of ordinary skill in plasma technology will therefor appreciate that "atmospheric pressure" as used herein should *not* be interpreted as the pressure unit "atm" defined as 101 325 Pa. Preferably, the plasma will maintain a pressure between 0,6 and 5,0 bar, more preferably the plasma will maintain a pressure between 0,7 and 4,5 bar, more preferably the plasma will maintain a pressure between 0,8 and 3,0 bar, more preferably the plasma will maintain a pressure between 0,9 and 2,5 bar, more preferably the plasma will maintain a pressure between 1,0 bar and 2,5 bar, most preferably a pressure above 1,0 bar and below 2,5 bar. Most preferably, the plasma will maintain a slightly higher pressure compared to the pressure of the environment. This is advantageous, particularly in combination with an apparatus according to the present invention, as this greatly reduces oxygen inflow from the environment into the plasma. As a result, a more stable, homogeneous plasma is obtained. Due to the increased homogeneity between the plasma jet and the surface of the substrate, milder plasma jet conditions can be used while retaining sufficient activity to produce a linking layer or immobilize biomolecules. This is particularly advantageous with plasma-sensitive molecules. Most biologically active molecules, such as proteins, are plasm a-sensitive.

In a preferred embodiment, the plasma gas used to generate both said plasma jets, is chosen from the groups comprising helium, argon, nitrogen, air, carbon dioxide, ammonium or a combination thereof. It is possible to use two different plasma gasses for each of the steps of the process. More preferably, argon is used as plasma gas in order to generate the second plasma jet. Argon produces a less aggressive climate and maintains epitope integrity. This allows plasma sensitive molecules, such as many biomolecules, which would otherwise denature in presence of plasma, to be immobilized onto the surface while retaining their biological functionality. More preferably, argon is used as plasma gas in order to generate said both plasma jets. This advantageously allows the use of the same plasma gas to generate both plasma jets. This also allows the use of plasma apparatus with a single plasma jet and multiple release precursor channels, which has a lower capital cost and a lower operating cost.

In a preferred embodiment, the first plasma jet is generated at a first electrode power and the second plasma jet is generated at a second electrode power, wherein the first electrode power is higher than the second electrode power. Lower second electrode power allows for the production of less energetic plasma, which is preferred to immobilize the plasma sensitive biomolecules, while a energetically higher plasma is beneficial for the deposition of the linking layer.

It is understood that a plasma jet is generated using electrodes, working at an electrode power. The first plasma jet is generated at a first electrode power. The second plasma jet is generated at a second electrode power. The "electrode power" as used herein is defined in function of the area of the plasma outlet of the nozzle. This more accurately represents the power input per affected surface area of the substrate.

In a preferred embodiment, the first electrode power is at least 1.0 W/cm², preferably at least 1.1 W/cm², more preferably at least 1.2 W/cm², more preferably at least 1.3 W/cm², more preferably at least 1.4 W/cm², more preferably about 1.5 W/cm². These electrode powers are suitable for a wide array of combinations of linking molecules and surfaces of substrates, particularly relatively inert substrates.

In a preferred embodiment, the second electrode power is at most 1.5 W/cm², preferably at most 1.4 W/cm², more preferably at most 1.3 W/cm², more preferably at most 1.2 W/cm², more preferably at most 1.1 W/cm², more preferably at most 1.0 W/cm², more preferably at most 0.9 W/cm², more preferably at most 0.8 W/cm², more preferably about 0.7 W/cm².

In a preferred embodiment, the first electrode power is at least 1.0 W/cm² and the second electrode power is at most 1.5 W/cm², more preferably the first electrode power is at least 1.1 W/cm² and the second electrode power is at most 1.4 W/cm², more preferably the first electrode power is at least 1.2 W/cm² and the second electrode power is at most 1.3 W/cm², more preferably the first electrode power is at least 1.2 W/cm² and the second electrode power is at most 1.2 W/cm², more preferably the first electrode power is at least 1.3 W/cm² and the second electrode power is at most 1.1 W/cm², more preferably the first electrode power is at least 1.4 W/cm² and the second electrode power is at most 1.0 W/cm², more preferably the first electrode power is at least 1.5 W/cm² and the second electrode power is at most 1.0 W/cm², more preferably the first electrode power is at least 1.6 W/cm² and the second electrode power is at most 1.0 W/cm², more preferably the first electrode power is at least 2.0 W/cm² and the second electrode power is at most 1.0 W/cm².

In a preferred embodiment, the substrate is chosen from the group comprising biological materials, composite materials, crystalline solids, textiles, metals, plastics, polymers, ceramics, glass or a combination thereof. Preferably the sample surface is chosen from the group consisting glass, quartz, plastics, polymers, textiles, silicon, skin, tissue or a combination thereof. Glass, quartz and silicon are particularly advantageous for research and diagnostic environments. They are reusable, relatively cheap and inert and are already used as an industry standard.

Tissue, textiles and skin are particularly advantageous for medical and diagnostic products to be used on living matter, such as wound dressing. The immobilization of the biological activity to a surface allows the more targeted use of biomolecules. The dispersion or absorption of biomolecules after application to living matter can be prevented. The biomolecule can be removed by removing the surface.

In a preferred embodiment, the linking molecule is a molecule comprising of at least one moiety. Preferably the linking molecule comprises two moieties. In a preferred embodiment, at least one moiety is suitable for the attachment of the linking layer to a biomolecule. A well-chosen moiety allows better, easier and stronger attachment of the biomolecule to the linking layer. This advantageously allows the use of more biomolecules, particularly molecules which are sensitive. This also allows the orientation of biomolecule on the linking layer to be targeted and steered. A beneficial orientation increases the availability of the biomolecule for living matter. In another preferred embodiment, a moiety is suitable for attachment of the linking molecules to the sample. This improves the binding strength between the linking layer and the surface of the substrate. In another preferred embodiment, a moiety is suitable for polymerization of the linking molecules. This allows the linking layer to form a polymer network which improves the binding strength between the surface of the substrate and the biomolecules. It can also improve the chemical and mechanical properties of the surface, for example increased hardness and reduced reactivity. In a further preferred embodiment, the attaching molecules comprise at least two moieties, wherein one is suitable for linking the linking molecule to the surface of the substrate and at least one is suitable for attaching the biomolecule to the linking layer. In the most preferred embodiment, these moieties are not located alongside each other, in order to minimize the occurrence of steric hindrance.

In a preferred embodiment, at least one moiety is chosen from the group comprising alkane, alkene, alkyne, benzene derivates, haloalkane, fluoroalkane, chloroalkane, bromoalkane, iodoalkane, alcohol, ketone, aldehyde, acyl halide, carbonate, carboxylate, carboxylic acid, ester, methoxy, hydroperoxide, peroxide, ether, hemiacetal, hemiketal, acetal, ketal, orthoester, heterocycle, orthocarbonate ester, amide, amines, imine, imide, azide, azo compound, cyanates, nitrate, nitrile, nitrite, nitro compound, nitroso compound, oxime, pyridine derivate, thiol, thioether, disulfide, sulfoxide, sulfone, sulfinic acid, sulfonic acid, sulfonate ester, thiocyanate, thioketone, thial, thioester, phosphine, phosphonic acid, phosphate, phosphodiester, boronic acid, boronic ester, borinic acid, borinic ester or a combination thereof. Preferably, the moiety is chosen from the group comprising carboxylic acid, thiol, hydroxyl, amine or trialkoxysilane. These moieties have been particularly well-suited for the attachment of plasma-sensitive biomolecules, particularly antibodies. This allows immobilization of these molecules onto substrates which are otherwise difficult to adhere to such as glass, quartz, plastics, polymers, textiles, silicon, skin, tissue or a combination thereof.

In a preferred embodiment, the biomolecule is a biologically or pharmaceutically active molecule.

In a preferred embodiment, the biomolecule is chosen from the group comprising of a protein, a polynucleotide, a sugar, a lipid, a growth factor, a hormone and a physiological active substance or a combination thereof. Preferably said biomolecule is an antibody or comprises antibacterial and/or antifungal activities. Immobilizing biologically or pharmaceutically active molecules is advantageous for research and diagnostics, in which controlled environments are desired. It is also advantageous for the targeted application of medicine. Biological or pharmaceutical activity which is bound to a surface can be applied in a specific place during a specific time in a very controlled manner. As such, the present invention is particularly suitable for use in the production of diagnostic devices or wound care products. Most preferably the biomolecule is an antibody. Antibodies are generally very plasma-sensitive. The present invention is particularly advantageous for immobilizing plasma-sensitive molecules.

In a preferred embodiment, the biomolecule is administered in a dissolved state. In a more preferred embodiment, the biomolecule is dissolved in an aqueous solvent. In another preferred embodiment, the biomolecule is inserted into the plasma jet as an aerosol. In a further preferred embodiment, the biomolecule is inserted into the plasma jet as an aqueous aerosol. Without being bound by theory, it is believed this allows the biomolecule to be protected by a watery shell upon insertion into the plasma jet, which helps retain its biological activity. Administration of the biomolecule through an aqueous aerosol also promotes even distribution of the biomolecule as the aerosol limits clustering. This improves the availability of the biomolecule on the surface of the substrate.

In one embodiment, the step of providing a linking layer comprises multiple steps creating multiple layers which serve as a linking layer. For example, a first linker could improve adhesion of the linker to the surface of the substrate. A second linker could link to the first linker, and improve immobilization of the biomolecule.

In another embodiment, the step of immobilizing biomolecules onto the linking layer comprises multiple steps. For example, several layers of biomolecules may be deposited as multiple layers. Alternatively, different biomolecules may distributed over the surface of the substrate. This can be advantageous to provide multiple or synergistic effects.

In one embodiment, the binding between the linking layer and the surface of the substrate is not permanent. In another embodiment, the binding between the linking layer and the biomolecule is not permanent. A non-permanent immobilization of a biomolecule allows the controlled release of a biomolecule in a target location.

In a second aspect, the invention provides an apparatus suitable for the two step immobilization of the biomolecule onto the sample surface of the substrate through a linking molecule. The apparatus comprises a plasma jet generator comprising a jet outlet. The apparatus furthermore comprises an adaptor and a replaceable shield. The shield comprises a jet inlet, a nozzle outlet and a sidewall extending from the jet inlet to the nozzle outlet. The adaptor is configured for detachably attaching the shield onto the plasma jet generator, and thereby communicatively coupling the jet outlet and the jet inlet.

"Communicatively coupled" as used herein refers to mass flow, i.e. fluid, gas and/or plasma flow. A communicatively coupled jet outlet of a plasma jet generator and jet inlet of a shield are therefore configured for a plasma jet exiting said jet outlet to enter the shield via jet inlet.

In a preferred embodiment, the jet outlet of the plasma jet generator comprises an opening and the jet inlet of the shield comprises an opening, whereby the opening of the jet inlet is larger than the opening of the jet outlet. This is advantageous as an enlargement results in a decrease in velocity and in a pressure rise, thereby aiding in creating the overpressure inside the shield with respect to the environment. This is further advantageous as a sharp enlargement may cause turbulent flow and/or recirculation and therefore mixing of the components present in a corresponding portion of the shield. Preferably, the shield comprises a length in between the jet inlet and the nozzle outlet, and said at least one precursor inlet is communicatively coupled with the inside of the shield within a distance of the jet inlet equal to at most 50% of said length, preferably at most 40% of said length, more preferably at most 30% of said length. This is advantageous as the inflow of precursors occurs in a region where the recirculation also occurs. This is further advantageous as the inflow of precursors occurs in a direction substantially non-parallel with, preferably in essence perpendicular to, the plasma jet inflow at the jet inlet, preferably in essence parallel to the length direction, thereby further augmenting the turbulent flow.

In a preferred embodiment, the nozzle comprises a homogenization means. Preferably, the shield comprises said homogenization means, preferably on the inside. The homogenization means may comprise flow disturbance elements. The flow disturbance elements may comprise a plurality of inclined surfaces. The flow disturbance elements may comprise a plurality of layers each comprising a multitude of inclined surfaces. A flow disturbance element may comprise a surface comprising an angle of at least 20° and at most 70° with the length direction of the shield.

Preferably, the shield is monolithic. A shield may be manufactured via injection molding. A shield may be manufactured via 3D printing. Preferably, a shield comprises an insulating material, more preferably a plastic. The nozzle outlet of the shield comprises an edge. The nozzle outlet of a shield may comprise a planar edge, i.e. the nozzle outlet is planar. The nozzle outlet of a shield may comprise a non-planar edge, i.e. the nozzle outlet is non-planar. This allows for in-line coating of non-planar surfaces, whereby a small distance is maintained between each portion of the edge and the surface.

In a preferred embodiment, the nozzle is adapted for cooling. Preferably, the sidewall of the shield comprises a channel for passage of a cooling fluid. The channel is preferably located at a distance from the nozzle outlet of at most 60%, more preferably at most 50%, even more preferably at most 45%, of the length of the shield.

In a preferred embodiment, the sidewall of the shield comprises at least one precursor inlet, preferably at least two precursor inlets, such as two, three, four or more precursor inlets. A precursor inlet may comprise a tubular hollow body comprising a first outer end communicatively coupled with the inside of the shield and a second outer end for communicative coupling with a precursor source. The tubular body may by cylindrical. The tubular body may comprise one or more bends. The coating precursors may be injected via said at least one precursor inlet in the plasma jet in the shield.

In a further preferred embodiment, one precursor inlet is a linking molecule precursor inlet and another precursor inlet is a biomolecule precursor inlet. In a further preferred embodiment, said biomolecule precursor inlet is suitable to aerosolize said biomolecule precursor, which is preferably a dissolved biomolecule in an aqueous medium. This apparatus is particularly advantageous as a single plasma jet can be used for both steps of the two-step method. The apparatus can be used for the two-step process wherein the same plasma-gas is used. This allows the process to be carried out more quickly and with lower capital costs than using two separate plasma jets.

In a preferred embodiment, the apparatus comprises a linking plasma jet generator comprising a linking jet outlet. Further, the apparatus comprises a biomolecule plasma jet generator comprising a biomolecule jet outlet. Furthermore, The apparatus comprises an adaptor and a replaceable shield. The adaptor is configured for detachably attaching the shield onto the linking plasma jet generator, the biomolecule plasma jet generator or both. Thereby, the adaptor selectively and communicatively couples the linking jet outlet, biomolecule jet outlet or both and the jet inlet.

In a third aspect, the invention discloses devices obtainable using the two step immobilization of the biomolecule onto the sample surface of the substrate through a linking molecule.

In a preferred embodiment, the product is a linker assisted antibody immobilized onto glass, quartz or silicon wafer suitable for diagnostic purposes.

In a preferred embodiment, the product is a patch for wound dressing, comprising of a textile patch functionalized with biomolecules which possess anti-bacterial properties, anti-fungal properties or both.

The invention is further described by the following non-limiting examples which further illustrate the invention, and are not intended to, nor should they be interpreted to, limit the scope of the invention.

The present invention will be now described in more details, referring to examples that are not limitative.

### Examples

### Methodology

The following buffers were used in these experiments. A Blocking buffer consisting of 25 ml PBS (Dulbecco's phosphate buffered saline, Gibco) and 0.25 g of BSA (Bovine serum albumin, Sigma-Aldrich) was created, shaken to make sure that everything has dissolved. A Storage buffer comprising 25 ml of Type I Ultra-pure water (Synergy UV Milli-Q Water, Millipore), 2.5 g of mannitol (D-mannitol ≥ 98%, Sigma-Aldrich) and 0.5 g of sucrose (D(+)-sucrose 99,7 %, Acros Organics). A Washing buffer comprising 150 ml PBS and 3 µl of Tween80 (Sigma-Aldrich). Care was taken due to the viscosity of Tween80. A PTA buffer comprising 150 ml PBS, 0.15 g of BSA and 3 µl of Tween80. An analytical balance was used to determine the mass of components.

All nozzles were specifically 3D printed for this experiment. The antibody solution (48 µg/ml) was prepared by adding 10 ml of PBS to a glass bottle (PlasmaSpot®) and pipetting 196 µl of goat origin anti-human IgE antibody (Novex, Invitrogen, USA) (Ab) into it. The solution was mixed by pipetting up and down. Glass beads (3 mm, Merck) were added until they reached the same level as the liquid in order to increase the volume.

An ice pack was taped to the bottle containing the solution to maintain the solution temperature at 4°C during deposition after which it was stored in the fridge. Two clean injectors were wetted by running the "cleaning atomizers" program for 5 minutes, using a suction flow of 4 slm. Deionized (DI) water was used for the antibody injector (Ab injector) and acrylic acid (CAS 79-10-7, abcr) (AA) for the acrylic acid injector (AA injector). The glass slides were cleaned by wiping them with a Nonwoven Wipe (TX609, TechniCloth®, Texwipe, USA) wetted with ethanol.

The slides were then argon plasma etched using PlasmaSpot® equipment and the "Spot Argon" program. The PlasmaSpot® head motion was set up to have an even deposition on the whole 75 mm x 25 mm surface. The etching was completed using a large round nozzle, 0 slm suction gas, 0 slm dilution gas, 100 W, 80 slm Argon (Air Liquide) and 2 passes of the head. Once the etching was completed, a PlasmaSpot® bottle containing 30 ml AA was attached to the AA injector. The head movement remained as previously set. A linker layer of AA was applied using a large round nozzle, 1 slm suction gas, 4 slm dilution gas, 100 W, 80 slm Argon and 2 passes of the head over each well. The glass ProPlate® (Grace Bio Labs) was assembled.

The extraneous variables were identified: suction gas, dilution gas, electrode power, electrode frequency, gas used for plasma, concentration of antibody solution, nozzle shape, nozzle-substrate separation, chemical used as reactive precursor, linker monolayer, substrate, substrate pre-deposition etching treatment. These variables were all kept constant in this trial.

The variables changed in this investigation were: suction flow, dilution flow, exposure time, presence and type of incubation, presence/absence of co-deposition of AA. The PlasmaSpot® head movement was disabled, and the nozzle was mounted. The AA bottle was left attached to the AA injector and the parameters were kept the same as in the pre-deposition method (1 slm suction gas, 4 slm dilution gas). The glass PlasmaSpot® bottle containing 10 ml anti IgE + PBS solution previously prepared was attached to the Ab injector and the suction flow and dilution flow were set according to the table below.

Four different combinations of suction and dilution flows were tested. First combination comprises 1 slm sunction flow and 4 slm dilution flow. Second combination comprises 2 slm sunction flow and 3 slm dilution flow. Third combination comprises 3 slm sunction flow and 2 slm dilution flow. Fourth combination comprises 4 slm sunction flow and 1 slm dilution flow.

The electrode power was set to 60 W and the frequency was kept constant at 38 kHz, the argon plasma gas flow was set to 80 slm. For the Ab only condition, only the Ab injector was used, and the AA injector was disabled, in the Ab + AA condition, both injectors were activated. The nozzle was inserted 2 mm into the well to be treated. Exposure times of 5 - 40 seconds were used, increasing in increments of 5 seconds. After each deposition, the head was moved to remove the nozzle from the well and insert it into the next one. Each condition was repeated in three wells. Once all the wells were treated, the plate was removed, and the appropriate incubation procedure was followed.

Three different incubation conditions were tested: wet incubation, dry incubation and no incubation. Wet incubation was prepared by adding 175 µl of PBS buffer to each well using a pipette (Multipipette M4 1 µl - 10 mL, Eppendorf) and tips (Combitips advanced 2,5 mL PCR clean, Eppendorf) and the plate was stored for 24 h at 4°C. The wells were then emptied by tapping on a NwW until no more residue appeared. 175 µl of PBS and 1 % BSA blocking buffer was pipetted into each well. The plate was then left to incubate for 2 hours at room temperature (RT) after which the wells were emptied by tapping on a NwW. Dry incubation was prepared by storing the plate at 4°C for 24 h. 175 µl of PBS and 1 % BSA blocking buffer was pipetted into each well. The plate was then left to incubate for 2 hours at RT and the wells emptied by tapping on a NwW. No incubation condition was prepared by pipetting 175 µl of PBS and 1 % BSA blocking buffer into each well. The plate was left to incubate for 2 hours at RT. The wells were then emptied by tapping on a NwW.

After incubation, the wells were washed by pipetting 175 µl of PBS and 0.002 % Tween 80 solution into them and emptying them on a NwW. This process was repeated 4 times. 175 µL/well of D-mannitol (100 g/L) and sucrose (20 g/L) storage buffer was added to each well and the plates were incubated for 3 mins at RT. The wells were then emptied by tapping on a NwW. Finally, the plates were wrapped in tin foil and stored at -20°C in a freezer.

The plates were removed from the freezer. The plates were washed 4 times by pipetting 150 µl PBS and 0.002 % Tween 80 into the wells, which were then emptied by tapping on a NwW. 175 µL/well of 10 ng/ml of IgE solution (Immunoglobine E myeloma kappa, Athens Research & Technology) in PTA was added and the plates were left to incubate at RT for 1 hour. One of the triplicate wells was always left empty to act as a blank. Each well was washed 4 times with PBS + 0.002 % Tween 80 and then emptied by tapping on a NwW. 175 µL/well of detection antibody, 1µg/ml biotin-anti IgE conjugate (Goat anti-human IgE antibody, biotin conjugated, cross-adsorbed, Invitrogen) in PTA, was added to each well. The plates were left to incubate at RT for 2 h. Each well was washed 4 times with PBS and 0.002 % Tween 80 and then emptied by tapping on a NwW. 175 µL/well of the resolving enzyme, 100 ng/ml streptavidin-HRP (Streptavidin horseradish peroxidase conjugate, Thermo Fisher) in PTA solution, was added to each well. The plates were then left at RT for 1 h. Each well was washed 4 times with PBS and 0.002 % Tween 80 and then emptied by tapping on a NwW. 100 µL/well of Tetramethylbenzidine (TMB) (1-Step Ultra TMB-ELISA, Thermo Scientific) was added. Remark: in the case of the second experiment 150 µl of TMB was added per well. Immediately after substrate addition, the plate was inserted into the spectrophotometer. The spectrophotometer shook the plates before starting and the standard was set as "costar corning plate black clear bottom". The absorbance of light at 370 nm and 652 nm wavelengths was measured every 5 minutes for 1 hour after TMB addition.

The examples and their reference number are shown in the table below. Examples 7 and 8 did not have any suction or incubation time as the exposure time was 0s.

| Example | Deposition | Suction | Exposure time | Incubation |
|---|---|---|---|---|
| Ex. 1 | AB | 4 slm | 10s | None |
| Ex. 2 | AB | 4 slm | 10s | Wet |
| Ex. 3 | AB | 2 slm | 20s | None |
| Ex. 4 | AB | 4 slm | 10s | Wet |
| Ex. 5 | AB + AA | 4 slm | 9s | None |
| Ex. 6 | Blank-AB + AA | 4 slm | 9s | None |
| Ex. 7 | AB | | 0s | |
| Ex. 8 | Blank-AB | | 0s | |
| Ex. 9 | Blank-AB | 2 slm | 20s | None |
| Ex. 10 | AB | 2 slm | 40s | None |
| Ex. 11 | Blank - AB | 2 slm | 40s | None |
| Ex. 12 | AB | 1 slm | 10s | None |
| Ex. 13 | Blank-AB | 1 slm | 10s | None |
| Ex. 14 | Blank-AB | 4 slm | 10s | None |
| Ex. 15 | AB + AA | 4 slm | 10s | Wet |
| Ex. 16 | AB + AA | 4 slm | 10s | Dry |

### Results

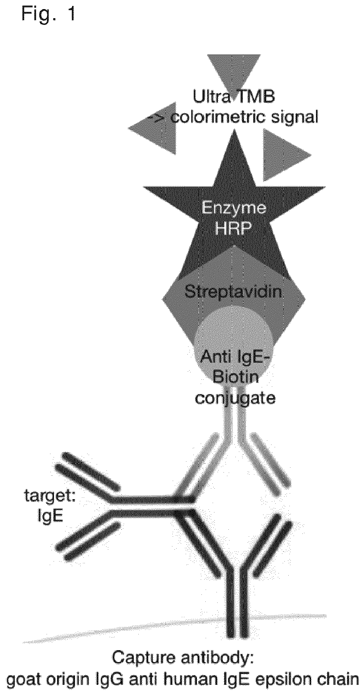

The exposure time, suction flow and dilution flow, incubation procedure and deposition method were manipulated to identify optimum conditions for antibody deposition using MPG's atmospheric plasma technology in order to optimize functionality demonstrated by the sandwich ELISA (Figure 1). The kinetics of the reaction can be deduced by the absorption curves as shown below. These show the affinity of the capture antibody for the target antibody and provide a measure of the functionality retained by the capture antibody. All endpoints were measured at 60 minutes as the reactions stabilized and reached an absorbance plateau after approximately 40 minutes.

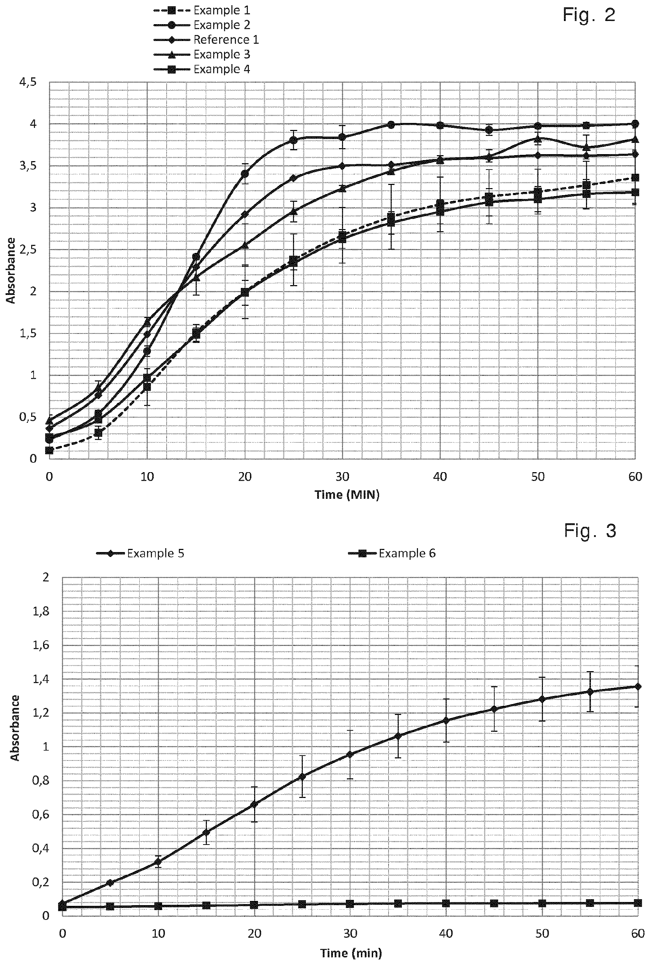

The capture antibody (Goat IgG anti-human IgE) was shown to retain its functionality as shown in Figure 2. This graph shows the best results from the trials compared to the reference curve provided by KU Leuven, obtained using their standards from the traditional wet chemistry deposition method on a polystyrene microtiter plate. The kinetics of each reaction differ and only one trial produced a signal indicating a faster reaction than the reference (Ex. 2 : 'only Ab, 4 slm, 10s, wet incubation'). It should also be noted that the reactions from the second trial ('only Ab, 4 slm, 10 s, wet incubation', 'only Ab, 4 slm, 10 s, no incubation' and 'only Ab, 2 slm, 20 s, no incubation') produced stronger signals which saturated earlier. This can be explained by the increased volume of TMB added in the second trial (150 µl rather than 100 µl). As all endpoints fall between 3-4 arbitrary units (arb. u.), they can all be considered comparable to the reference. This indicates that the atmospheric plasma deposition method is comparable to the current method in terms of functionality retention and that low energy plasma exposure does not result in denaturation due to structural changes. The specificity of the antibodies was determined by the testing of blank samples for each of the conditions tested. The blanks were created by not adding the target IgE in the ELISA protocol except for one in which no capture antibody was deposited. Figures 3 to 5 show the comparison between blanks and positive samples, which indicate that no non-selective binding is taking place and therefore the signal produced is due to the binding of the capture antibody to the target antibody.

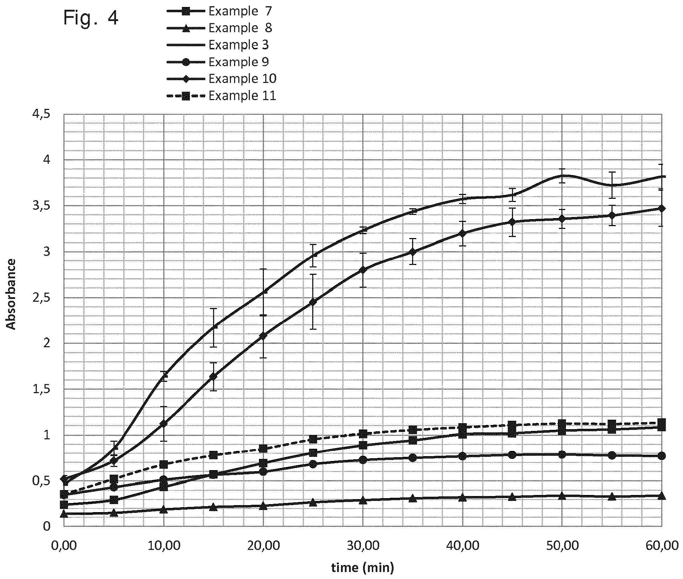

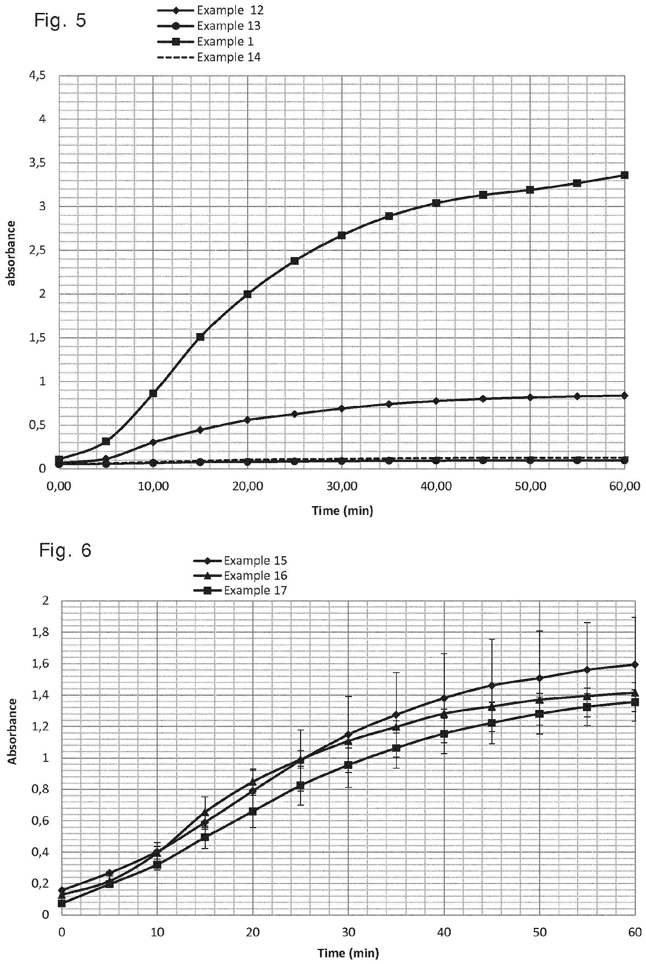

The signals produced by the blanks are sufficiently lower than those produced by the respective positive samples both when the Ab and AA were co-deposited (Fig. 3) and when the Ab was deposited alone (Fig 4). This is also the case when no capture antibodies were deposited as seen in Fig. 4. In this trial, no capture antibody was present and so the target IgE could only interact with the carboxylic groups of the polyacrylic acid linker layer. As the signal produced is very low and comparable to those produced by the trials lacking the target IgE, we can conclude that there is no cross-reaction occurring between the polyacrylic acid layer and the target IgE or other elements of the assay. Figure 5 shows that there is also no increase in cross-reaction if the suction flow is increased from 1 slm to 4 slm, which shows that this factor does not impact the specificity of the Ab as measured.

This illustrates that atmospheric plasma deposition can create specific bioassays and that the process does not interfere with the conformation of the antibody, therefore not affecting its specificity.

The effect of incubation was measured by following three different incubation protocols, while keeping all other parameters the same, and comparing the effects of the reaction on the kinetics. The incubation period is critical for the wet chemistry method, so determining its necessity with regards to atmospheric plasma deposition showed another way in which time could be saved, increasing the ease with which the process can be industrialized.

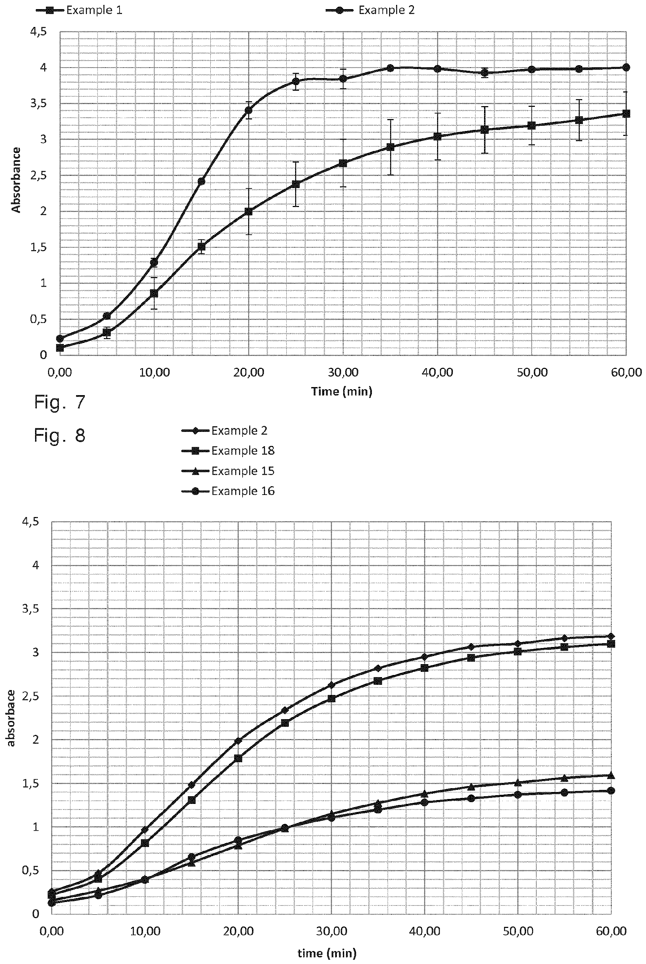

The different incubation steps were completed for the trials with and without the co-deposition of AA as shown in Figures 6 and 7. In both cases, the data show that the incubation step does not significantly increase the endpoint value of absorption, suggesting that the incubation step is not necessary when depositing antibodies using atmospheric plasma. The curves in Figure 6 indicate that the kinetics of all reactions are similar, however, the kinetics of the wet incubation trial were faster as shown in Figure 7. This can be explained by the fact that the 'only Ab, 4 slm, 10 s, wet incubation' (Fig. 7) was completed in the second trial and so had more TBM which would have saturated the HRP faster, producing a faster change in absorbance and earlier saturation.

Heyse et al. 2011 argued that co-deposition, defined as the simultaneous plasma polymerization of a chemical and deposition of the protein, would lead to the proteins being trapped in the polymer mesh, increasing the strength of the deposition. To test this theory, the Ab were deposited with and without AA while keeping all other parameters the same.

As seen in Fig. 8, the data contradict the theory of Heyse et al. as the absorption and rate of reaction of the trials without co-deposition of AA are higher. This suggests that antibody immobilization is either still successful without the addition of a co-precursor or that the co-deposition results in steric hinderance of the antibody binding sites, decreasing the IgE target conjugation.

It makes sense that the deposition conditions would affect the amount of capture antibody immobilized in the wells. This in turn will affect the amount of IgE which binds to the capture Ab and so, the absorbance measured. To investigate this, the several deposition parameters were changed to try and identify the ideal deposition conditions.

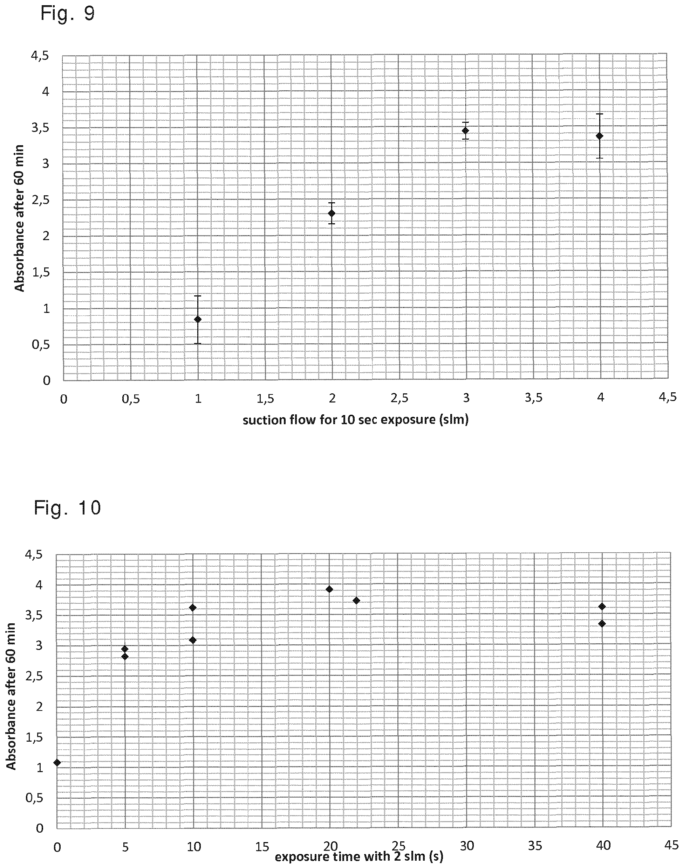

Figure 9 shows the endpoints of the reactions plotted against the suction flow used for the deposition, for the samples using only AB-deposition at 10s exposure time and with no incubation. It was thought that the higher the suction flow, the more antibodies deposited and therefore the stronger the signal produced in the ELISA, however this is not the case. The endpoint only increases to 3 slm and then decreases. This may be due to steric hinderance caused by excess antibodies.

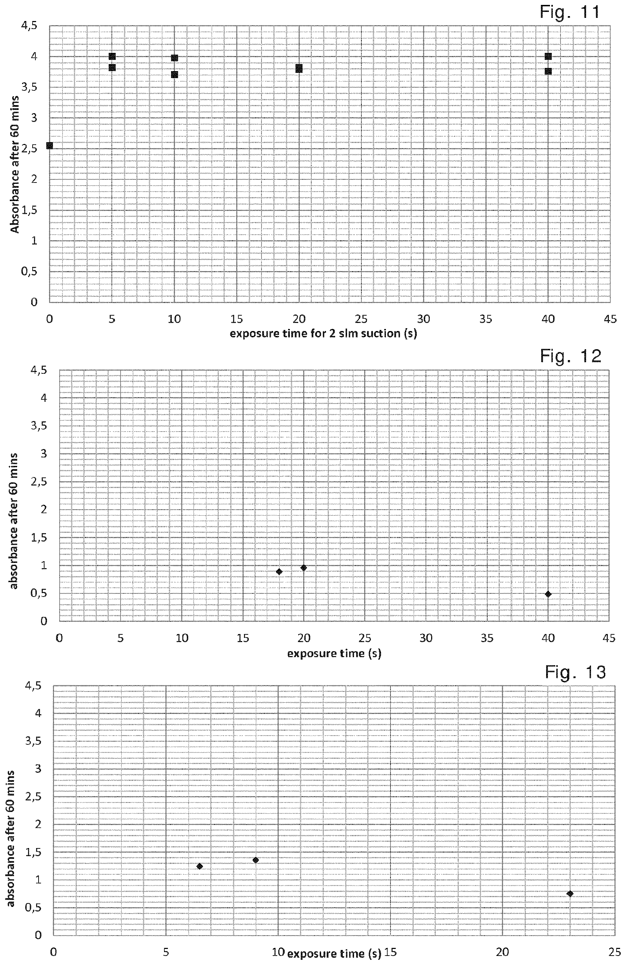

Figure 10 shows the absorbance after 60 minutes in function of the exposure time in seconds, with a constant suction of 2 slm for no incubation. Figure 11 shows absorbance after 60 minutes in function of the exposure time in seconds, with a constant suction of 2 slm for wet incubation. Exposure time was also thought to correlate with the amount of antibodies deposited, therefore the stronger the signal produced in the ELISA. Again, this was found not to be true as can be seen in Figures 10 and 11. Here the endpoint signal is shown to increase but then plateau between 10 and 20 seconds (Fig. 11 and 10 respectively), showing that the presence of more antibodies present does not necessarily result in a more effective test. Figures 12 and 13 show that at a certain point, the signal starts to decrease of the exposure time is lengthened (23 seconds in Fig. 13 and 40 seconds in Fig. 12). We can determine from this that short exposure times can be used with similar effects, further decreasing the time needed to immobilize the antibodies.

Antibody immobilization using atmospheric plasma technology has been shown to be a viable method as antibody functionality was maintained at the same level as traditional wet chemical methods. It was also shown that the specificity of the antibody active sites was maintained as no cross-reaction or non-specific binding was seen to take place in blank samples. It was concluded that the incubation step is obsolete in this method of antibody immobilization as neither wet nor dry incubation significantly increase the signal of the ELISA. Furthermore, it was found that the deposition of Ab without AA increased the signal of the ELISA, due to steric hinderance produced by the mesh of AA formed in co-deposition. The optimum parameters of deposition were also investigated, and it was concluded that if suction flow and exposure time are too high, the functionality of the antibodies is impeded.

## Claims

1. A two step method for the immobilization of a biomolecule through a linking molecule on a sample surface of a substrate by generating and maintaining a non-thermal atmospheric pressure plasma at a temperature between room temperature and 60°C, preferably at room temperature, the method comprising the two steps of:
- in a first step the linking molecule is deposited onto the sample surface through exposing the sample surface to a first plasma jet and the linking molecule, generating a linking layer onto the sample surface; and
- sequentially, in a second step the biomolecule is deposited onto the linking layer through exposing the linking layer to a second plasma jet and the biomolecule.

2. The method according to claim 1, wherein the plasma jet can be generated using a plasma gas, which is chosen from the group comprising helium, argon, nitrogen, air, carbon dioxide, ammonium or a combination thereof, preferably argon is used as plasma gas to generate the second plasma jet.

3. The method according to any of claims 1 or 2, wherein the first plasma jet is generated at a first electrode power and the second plasma jet is generated at a second electrode power, wherein said first electrode power is higher than said second electrode power.

4. The method according to any of claims 1-3, wherein the first plasma jet is generated at a first electrode power and the second plasma jet is generated at a second electrode power, wherein the first electrode power is at least 1.0 W/cm² and wherein the second electrode power is at most 1.5 W/cm².

5. The method according to any of claims 1-4, wherein preferably the substrate is chosen from the group comprising biological materials, composite materials, crystalline solids, textiles, metals, plastics, polymers, ceramics, glass or a combination thereof, more preferably the sample surface is chosen from the group consisting glass, quartz, plastics, polymers, textiles, silicon, skin or tissue.

6. The method according to any of claims 1-5, wherein the linking molecule is a molecule comprising of at least one moiety, preferably the linking molecule comprises two moieties, more preferably the two moieties are not located alongside each other.

7. The method according to any of claims 1-6, wherein at least one moiety is chosen from the group comprising alkane, alkene, alkyne, benzene derivates, haloalkane, fluoroalkane, chloroalkane, bromoalkane, iodoalkane, alcohol, ketone, aldehyde, acyl halide, carbonate, carboxylate, carboxylic acid, ester, methoxy, hydroperoxide, peroxide, ether, hemiacetal, hemiketal, acetal, ketal, orthoester, heterocycle, orthocarbonate ester, amide, amines, imine, imide, azide, azo compound, cyanates, nitrate, nitrile, nitrite, nitro compound, nitroso compound, oxime, pyridine derivate, thiol, thioether, disulfide, sulfoxide, sulfone, sulfinic acid, sulfonic acid, sulfonate ester, thiocyanate, thioketone, thial, thioester, phosphine, phosphonic acid, phosphate, phosphodiester, boronic acid, boronic ester, borinic acid, borinic ester or a combination thereof, preferably the moiety is chosen from the group comprising carboxylic acid, thiol, hydroxyl, amine or trialkoxysilane.

8. The method according to any of claims 1-7, wherein said biomolecule is a biologically or pharmaceutically active molecule.

9. The method according to any of claims 1-8, wherein said biomolecule is chosen from the group comprising of a protein, a polynucleotide, a sugar, a lipid, a growth factor, a hormone and a physiological active substance or a combination thereof, preferably said biomolecule is a antibody or comprises antibacterial and/or antifungal activities, most preferably the biomolecule is an antibody.

10. The method according to any of claims 1-9, wherein said biomolecule is administrated to the second plasma jet in an aqueous aerosol.

11. Apparatus adequate for achieving the method according to any of claims 1-10 comprises:
- a plasma jet generator (1) comprising a jet outlet (12); and
- a nozzle comprising an adaptor (3) and a replaceable shield (2), the shield comprising a jet inlet (22), a nozzle outlet (24) and a sidewall (21) extending from the jet inlet to the nozzle outlet,
wherein the adaptor is configured for detachably attaching the shield onto the plasma jet generator and thereby communicatively coupling the jet outlet and the jet inlet.

12. Apparatus according to any of claim 11, wherein said apparatus comprises:
- a linking plasma jet generator comprising a linking jet outlet; and
- a biomolecule plasma jet generator comprising a biomolecule jet outlet,
wherein said adaptor is configured for detachably attaching the shield onto the linking plasma jet generator, the biomolecule plasma jet generator or both and thereby selectively communicatively coupling the linking jet outlet, biomolecule jet outlet or both and the jet inlet.

13. Products obtainable using the method according to any of claims 1-10.

14. Product according to claim 13, wherein the product is a linker assisted antibody immobilized onto glass, quartz or silicon wafer suitable for diagnostic purposes.

15. Product according to claim 13, wherein the product is a patch for wound dressing, comprising of a textile patch functionalized with biomolecules which possess anti-bacterial properties, anti-fungal properties or both.
